# EUROPEAN PATENT SPECIFICATION

(11) **EP 4 149 230 B1**
(45) Date of publication and mention of the grant of the patent: **03.09.2025**
(21) Application number: 21826188.1
(22) Date of filing: 16.06.2021
(51) Int. Cl.: H05K 9/00, H05K 7/20, H04M 1/02, G06F 1/18

(54) **ELECTRONIC DEVICE COMPRISING GROUND CONNECTION STRUCTURE**
ELEKTRONISCHE VORRICHTUNG MIT ERDVERBINDUNGSSTRUKTUR
DISPOSITIF ÉLECTRONIQUE COMPRENANT UNE STRUCTURE DE CONNEXION À LA MASSE

(30) Priority: 16.06.2020 KR 20200073133
(43) Date of publication of application: 15.03.2023
(73) Proprietor: Samsung Electronics Co., Ltd., Gyeonggi-do 16677 (KR)
(72) Inventor: JEONG, Wooyoung, Suwon-si, Gyeonggi-do 16677 (KR); KIM, Suyeon, Suwon-si, Gyeonggi-do 16677 (KR); KIM, Minho, Suwon-si, Gyeonggi-do 16677 (KR); PARK, Jinwoo, Suwon-si, Gyeonggi-do 16677 (KR); WOO, Yongjin, Suwon-si, Gyeonggi-do 16677 (KR); LEE, Jongmin, Suwon-si, Gyeonggi-do 16677 (KR)
(74) Representative: Gulde & Partner
(86) International application number: PCT/KR2021/007566
(87) International publication number: WO 2021/256859

(56) References cited:
- WO-A1-2020/101274
- JP-A- 2015 126 108
- KR-A- 20170 004 259
- KR-B1- 101 917 787
- KR-B1- 101 969 029
- US-A1- 2014 063 821
- US-A1- 2017 155 746
- US-A1- 2018 007 817

## Description

### [Technical Field]

Embodiments of the disclosure relate to an electronic device including a ground connection structure.

### [Background Art]

An electronic device may include a metal part forming at least a portion of an outer appearance. The metal part may form a path for dissipating heat emitted from the inner part of the electronic device. In addition, at least a portion of the electronic device may form the ground of the electronic device, together with the ground area of a circuit board.

An electrostatic discharge (ESD) (e.g., static electricity) may be applied to the metal part of the electronic device. The ESD may disturb the operation of electronic devices. The electronic device should sufficiently be grounded to be operable (e.g., robustness) even when the ESD is applied. In similar regards, publication US20170155746A1 relates to an electronic device with heat radiating structures added to printed circuit boards and publication US20180007817A1 relates to a portable electronic device with an embedded electric shock protection function.

### [Disclosure]

### [Technical Problem]

A mobile electronic device may include more many electrical devices and larger batteries, as various functions are added and required performance increases. The area of the circuit board is more reduced, and the heat is increasingly emitted from the inner part of the electronic device. The circuit board reduced in size may not provide a sufficient grounding function against the ESD (e.g., static electricity). Meanwhile, recently, the electronic device may include a vapor chamber to effectively resolve the increased heat.

According to embodiments of the disclosure, there is provided an electronic device including a ground connection structure to form a discharge path including the vapor chamber and the metal part of the housing.

### [Technical Solution]

The invention is set out in the appended set of claims. According to embodiments of the disclosure, an electronic device includes a housing including a metal part, in which the metal part includes a frame structure forming a portion of a surface of the electronic device and a plate structure extending into an inner space of the housing, a printed circuit board disposed in the plate structure, a camera module disposed in the plate structure, in which the camera module includes a connector coupled to the printed circuit board, and the connector includes a conductive pad electrically connected to a ground area of the camera module, a vapor chamber interposed between the plate structure and the printed circuit board, having a conductivity, and at least partially facing the conductive pad of the connector, an electrical absorption member interposed between the vapor chamber and the conductive pad, an insulating adhesive member interposed between the vapor chamber and the plate structure, and a varistor electrically connect the vapor chamber to the metal part.

According to embodiments of the disclosure, an electronic device includes a front plate, a rear plate opposite to the front plate, a metal housing extending to a space between the front plate and the rear plate, a display disposed in the metal housing such that the display is viewed through the front plate, a conductive vapor chamber interposed between the metal housing and the rear plate, and a varistor to be electrically coupled to the metal housing and the vapor chamber. The varistor may be configured to form an electric short circuit between the metal housing and the vapor chamber, when static electricity is applied to the metal housing.

### [Advantageous Effects]

According to embodiments of the disclosure, the vapor chamber is extended to the camera module to improve the dissipation performance of the electronic device. In addition, when the ESD (e.g., the static electricity) is applied, the vapor chamber and the metal part of the housing serve as the ground, thereby preventing the internal components from being damaged or preventing the camera module from erroneously operating.

Besides, a variety of effects directly or indirectly understood through the disclosure may be provided.

### [Description of Drawings]

FIG. 1 is a front perspective view of an electronic device, according to an embodiment;
FIG. 2 is a rear perspective view of an electronic device, according to an embodiment;
FIG. 3 is a exploded perspective view of an electronic device, according to an embodiment;
FIG. 4 is a rear view of an electronic device, according to an embodiment;
FIG. 5 is a rear view of an electronic device, according to an embodiment;
FIG. 6 is a sectional view of an electronic device, according to an embodiment;
FIG. 7 is a sectional view illustrating a conductive buffer member, an electrical absorption member, and a vapor chamber of an electronic device, according to an embodiment; and
FIG. 8 is a view illustrating a ground structure of an electronic device, according to an embodiment.

With regard to description of drawings, the same or similar components will be marked by the same or similar reference signs.

### [Mode for Invention]

Hereinafter, various embodiments of the disclosure may be described with reference to accompanying drawings. However, those of ordinary skill in the art will understand that the disclosure is not limited to a specific embodiment, and modifications, equivalents, and/or alternatives on the various embodiments described herein can be variously made as long they are within the limits as defined by the appended claims.

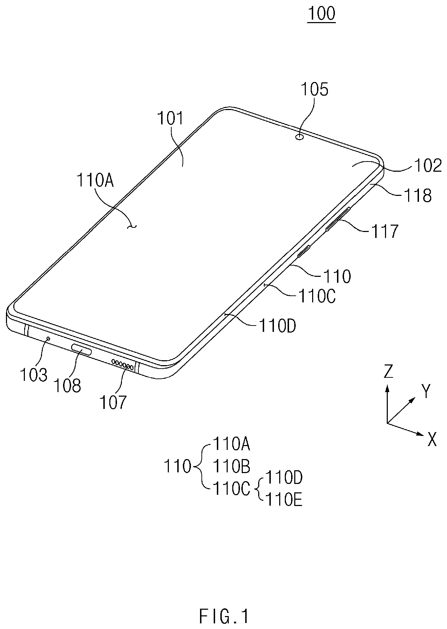

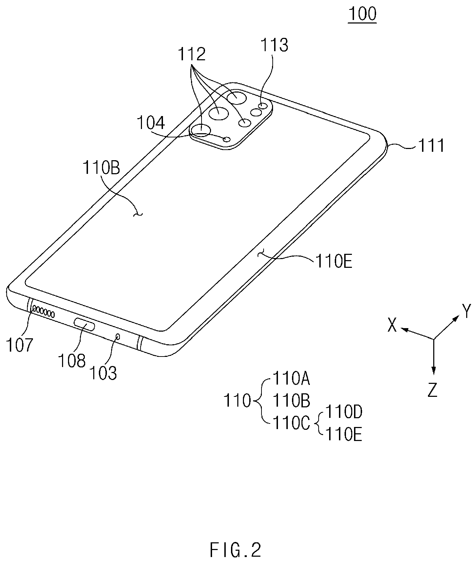

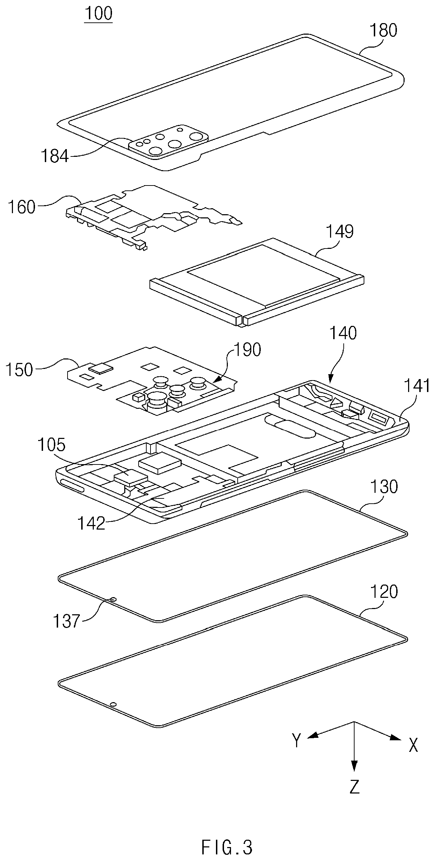

FIG. 1 is a front perspective view of an electronic device, according to an embodiment. FIG. 2 is a rear perspective view of an electronic device, according to an embodiment. FIG. 3 is an exploded perspective view of an electronic device, according to an embodiment.

Referring to FIGS. 1 and 2, an electronic device 100 may include a housing 110 including a first surface 110A (or front surface), a second surface 110B (or rear surface), and a side surface 110C surrounding the space between the first surface 110A and the second surface 110B.

According to another embodiment (not illustrated), the housing 110 may be referred to as the structure forming some of the first surface 110A, the second surface 110B, and the side surface 110C of FIG. 1.

According to an embodiment, the first surface 110A may include a front plate 102 (e.g., a glass plate or a polymer plate including various coating layers) having at least a portion substantially transparent. The second surface 110B may be formed through a rear plate 111 substantially opaque. The rear plate 111 may include, for example, coating or colored glass, ceramic, polymer, metal (e.g., aluminum, stainless steel (STS), or magnesium) or the combination of tat least two of the above materials. The side surface 110C may include a frame structure 118 which is coupled to the front plate 102 and the rear plate 111, and includes metal and/or polymer.

According to an embodiment, the rear plate 111 and the frame structure 118 may be formed integrally with each other and may include the same material (e.g., a metal material such as aluminum).

According to an embodiment illustrated in FIG. 1, the front plate 102 may include two first areas 110D bent toward the rear plate 111 from the first surface 110A while seamlessly extending, and formed at opposite long edge ends of the front plate 102.

According to an embodiment illustrated (see FIG. 2), the rear plate 111 may include two second areas 110E which is bent from the second surface 110B toward the front plate 102 while seamlessly extending and formed at opposite long edge ends of the rear plate 111.

According to an embodiment, the front plate 102 (or the rear plate 111) may include only one of the first areas 110D (or the second areas 110E). According to another embodiment, the front plate 102 (or the rear plate 111) may include some of the first areas 110D (or the second areas 110E).

According to embodiments, when viewed from the side surface of the electronic device 100, the frame structure 118 may have a first thickness (or width) on one side surface (e.g., a shorter side) where the first areas 110D or the second areas 110E are not included, and may have a second thickness smaller than the first thickness on a side surface (e.g., a longer side) in which the first ares 110D or the second areas 110E are included.

According to an embodiment, the electronic device 100 includes at least one a display 101, audio modules 103, 107, and 114 (e.g., the audio module 170 of FIG. 1), a sensor module (not illustrated) (e.g., the sensor module 176 of FIG. 1), camera modules 105, and 112 (e.g., the camera module 180 of FIG. 1), a key input device 117 (e.g., the input device 150 of FIG. 1), a light emitting device 106, and connector holes 108 and 109 (e.g., the connector 178 of fig. 1). According to an embodiment, the electronic device 100 may include remaining components except for at least one (e.g., the key input device 117) of the above-described components or may additionally include another component (e.g., the light emitting device 106).

According to an embodiment, the display 101 may be exposed through substantial parts of the front plate 102. According to an embodiment, at least a portion of the display 101 may be exposed through the front plate 102 including the first surface 110A and first areas 110D of the side surface 110C.

According to an embodiment, a corner of the display 101 may be formed to be substantially identical in shape to an outer portion of the front plate 102, which is adjacent thereto. According to another embodiment (not illustrated), to expand an area for exposing the display 101, the distance between an outer portion of the display 101 and an outer portion of the front plate 102 may be substantially uniformly formed.

According to an embodiment, the surface (or the front plate 102) of the housing 110 may include a screen display area formed as the display 101 is visually exposed. For example, the screen display area may include the first surface 110A and first areas 110D of the side surface.

According to an embodiment, the screen display areas 110A and 110D may include a sensing area (not illustrated) configured to obtain biometric information of a user. In this case, the wording "the screen display areas 110A and 110D may include a sensing area" may be understood as that at least a portion of the sensing area may be overlapped with the screen display areas 110A and 110D. For example, the sensing area may be an area to display visual information by the display 101 and to additionally obtain the biometric information (e.g., a fingerprint) of the user, which is similar to another area of the screen display areas 110A and 110D.

According to an embodiment, the screen display area (110A, 110D) of the display 101 may include an area 110G for visually exposing the first camera module 105 (e.g., a punch through camera). For example, at least a portion of an edge of the area for exposing the first camera module 105 (e.g., the punch hole camera) may be surrounded by the screen display areas 110A and 110D. According to an embodiment, the first camera module 105 may include a plurality of camera modules (e.g., the camera module 180 of FIG. 1).

According to another embodiment (not illustrated), the display 101 may be coupled or disposed adjacent to a touch sensing circuit, a pressure sensor to measure the intensity (pressure) of a touch, and/or a digitizer to detect the stylus pen based on an electromagnetic scheme.

According to an embodiment, the audio modules 103, 104, and 107 may include microphone holes 103 and 104 and speaker holes 107.

According to an embodiment, a microphone may be disposed in a microphone hole 103 to obtain external sound. According to an embodiment, the microphone may include a plurality of microphones to sense the direction of the sound. According to an embodiment, the microphone hole 104) formed in a partial area of the second surface 110B may be disposed to be adjacent to the camera modules 105, 112, and 113. For example, the microphone hole 104 may obtain sound when the camera modules 105, 112, and 113 are executed, or may obtain a sound, when another function is executed.

According to an embodiment, the speaker holes 107 and 114 may include an external speaker hole 107 and a receiver hole 114 for conversation. According to an embodiment, the speaker hole 107 and 114 and the microphone hole 103 may be implemented in the form of one hole.

According to an embodiment, the electronic device 100 may include a speaker to communicate with the speaker hole 107. According to an embodiment, the speaker may include a piezoelectric speaker having no the speaker hole 107.

According to an embodiment, a sensor module (not illustrated; the sensor module 176 of FIG. 1) may generate an electrical signal or a data value corresponding to an internal operating state or an external environment state of the electronic device 100. For example, the sensor module may at least one of a proximity sensor, an HRM sensor, a fingerprint sensor, a gesture sensor, a gyro sensor, an air pressure sensor, a magnetic sensor, an acceleration sensor, a grip sensor, a color sensor, an infrared sensor, a biometric sensor, a temperature sensor, a humidity sensor, or an illuminance sensor.

According to an embodiment, the camera modules 105, 112 and 113 may include the first camera module 105 (e.g., a punch hole camera) exposed to the first surface 110A of the electronic device 100, and/or the second camera module 112 exposed to the second surface 110B, and/or the flash 113.

According to an embodiment, the first camera module 105 may be exposed through a portion of the screen display areas 110A and 110D of the display 101. For example, the first camera module 105 may be exposed through a portion of the screen display area 110A and 110D through an opening (not illustrated) formed in a portion of the display 101.

According to an embodiment, the second camera module 112 may include a plurality of camera modules (e.g., dual cameras or triple cameras). However, the second camera module 112 is not limited to necessarily including a plurality of camera modules, and may include one camera module.

The first camera module 105 and the second camera module 112 may include one or more lenses, an image sensor, and/or an image signal processor. The flash 113 may include, for example, a light-emitting diode or a xenon lamp. According to an embodiment, at least two lenses (an infrared camera, a wide-angle lens, and a telephoto lens) and image sensors may be disposed on one side surface of the electronic device 100.

According to an embodiment, the key input device 117 may be disposed on the side surface 110C (e.g., the first areas 110D and/or the second areas 110E) of the housing 110. According to an embodiment, the electronic device 100 may not include some or an entire portion of the key input device 117 mentioned above, and the key input device 117, which is not included, may be implemented in different forms, such as a soft key, on the display 101. According to an embodiment, the key input device may include a sensor module (not illustrated) forming the sensing area (not illustrated) included in the screen display areas 110A and 110D.

According to an embodiment, the connector hole 108 may receive a connector. According to an embodiment, the connector hole 108 may be disposed on the side surface 110C of the housing 110. According to an embodiment, the electronic device 100 may include a first connector hole 108 to transmit/receive power and/or data together with an external electronic device and a second connector hole (not illustrated), and a second connector hole (not illustrated) to receive a connector (e.g., an earphone jack) to transmit/receive the audio signal together with the external electronic device.

According to an embodiment, the electronic device 100 may include a light emitting device (not illustrated). For example, the light emitting device may be disposed on the first surface 110A of the housing 110. The light emitting device may provide state information of the electronic device 100 in the form of light. According to an embodiment, the light emitting device may provide a light source linking to the operation of the first camera module 105. For example, the light emitting device may include an LED, an infrared light emitting device (IR LED), and/or a xenon lamp.

Referring to FIG. 3, the electronic device 100 may include a front plate 120 (e.g., the front surface 110A and the first area 110D of FIG. 1), a display 130 (e.g., the display 101 of FIG. 1), a bracket 140, a battery 149, a printed circuit board 150, a support member 160 (e.g., a rear case), and a rear surface plate 180 (e.g., the rear surface 110B and the second area 110E of FIG. 1).

According to an embodiment, the electronic device 100 may not include at least one (e.g., the support member 160) of the components or may further include any other component. At least one of components of the electronic device 100 may be identical to or similar to at least one of components of the electronic device 100 of FIG. 1 or FIG. 2, and the duplicated description will be omitted below.

According to an embodiment, at least a portion of the front plate 120, the rear plate 180, and the bracket 140 (e.g., the frame structure 241) may constitute a housing (e.g., the housing 110 of FIGS. 1 and 2).

According to an embodiment, the bracket 140 may include a frame structure 141 constituting the surface (e.g., a portion of the side surface 110C of FIG. 1) of the electronic device 100, and a plate structure 142 extending inward of the electronic device 100 from the frame structure 141.

The plate structure 142 may be positioned inside the electronic device 100, and may be connected to the frame structure 141 or may be formed integrally with the frame structure 2451. For example, the plate structure 142 may be formed of, for example, a metal material and/or a non-metal material (e.g., polymer). The plate structure 142 may have one surface to be coupled to the display 130, and an opposite surface to be coupled to the printed circuit board 150. The printed circuit board 150 may include a processor, a memory, and/or an interface. The processor may include, for example, one or more of a central processing unit, an application processor, a graphic processing device, an image signal processor, a sensor hub processor, or a communication processor.

The memory may include, for example, a volatile memory and/or a non-volatile memory.

The interface may include, for example, a high definition multimedia interface (HDMI), a universal serial bus (USB) interface, an SD card interface, and/or an audio interface. The interface may electrically or physically connect, for example, the electronic device 100 with an external electronic device and may include a USB connector, an SD card/MMC connector, or an audio connector.

According to an embodiment, the battery 149 may supply power to at least one of components of the electronic device 100. For example, the battery 149 may include a primary battery, which is not rechargeable, a secondary battery which is rechargeable, or a fuel cell. According to an embodiment, at least a part of the battery 149 may be positioned on substantially the same dielectric layer as the printed circuit board 150. According to an embodiment, the battery 149 may be disposed inside the electronic device 100 integrally with the electronic device 100, and may be detachably disposed from the electronic device 101.

According to an embodiment, the first camera module 105 may be disposed in the plate structure 142 of the bracket 140, such that a lens is exposed to a partial area of the front plate 120 (e.g., the front surface 110A of FIG. 1) of the electronic device 100.

According to an embodiment, the first camera module 105 may be disposed such that an optical axis of a lens is partially aligned with a hole or a recess 137 formed in the display 130. For example, the area for exposing the lens may be formed on the front plate 120. For example, at least a portion of the first camera module 105 may include a punch hole camera disposed in the hole or the recess 137 formed in the rear surface of the display 130.

According to an embodiment, the second camera module 190 (e.g., the second camera module 112 of FIG. 2) may be disposed on the printed circuit board 150, such that the lens is exposed to the camera area 184 of the rear plate 180 (e.g., the rear surface 110B of FIG. 2B) of the electronic device 100.

According to an embodiment, the camera area 184 may be formed on the surface (e.g., the rear surface 110B of FIG. 2) of the rear plate 180. According to an embodiment, the camera area 184 may be formed to be at least partially transparent such that external light is incident to the lens of the second camera module 190. According to an embodiment, at least a portion of the camera area 184 may protrude to a specific height from the surface of the rear plate 180. However, the disclosure is not limited thereto. The camera area 184 may form substantially the same plane as the surface of the rear plate 180.

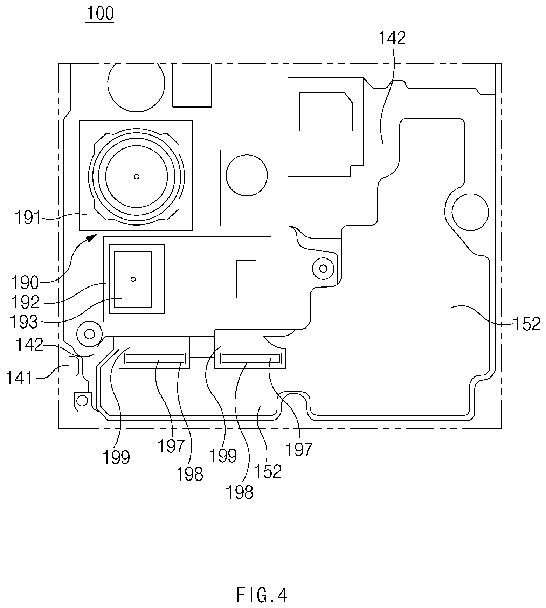

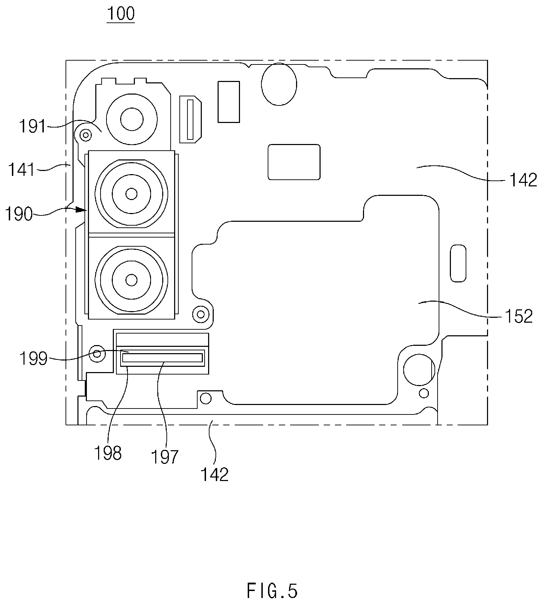

FIG. 4 is a rear view of an electronic device, according to an embodiment. FIG. 5 is a rear view of an electronic device, according to an embodiment. FIGS. 4 and 5 are views in which a rear plate and a printed circuit board of an electronic device illustrated in FIG. 3 is omitted.

Referring to FIGS. 4 and 5, the electronic device 100 includes the housing 140, the camera module 190 including the connector 199, and a vapor chamber 152, when viewed from the rear surface.

According to an embodiment, the housing 140 includes the frame structure 141 constituting the surface (e.g., a portion of the side surface 110C of FIG. 1) of the electronic device 100, and the plate structure 142 extending from the frame structure 141. According to an embodiment, the frame structure 141 may be formed to surround at least a portion of the edge of the plate structure 142. According to various embodiments, the frame structure 141 may be formed integrally with the plate structure 142 or in the form of a member separate from the plate structure 142 to be coupled to the plate structure 142. According to an embodiment, the camera module 190 and the vapor chamber 152 may be disposed in the plate structure 142. According to an embodiment, the camera module 190 and the vapor chamber 152 may be disposed on a first surface 142a of the plate structure 142. For example, the first surface 142a of the plate structure 142 may be a surface facing in a direction opposite to a direction in which the display 130 is disposed.

According to an embodiment, the camera module 190 may include a first camera module 190 allowing the optical axis of the lens to face the rear surface, a second camera module 190 allowing the optical axis of the lens to face the side surface. For example, the second camera module 190 may further include a prism 193 to refract light. Each of the first camera module 190 and the second camera module 190 may include a plurality of camera devices.

According to an embodiment, the camera module 190 includes a connector(s) 199. The connector 199 may be coupled to the printed circuit board 150. For example, the connector 199 is physically coupled to a corresponding connector 154 included in the printed circuit board 150. According to an embodiment, the connector 199 may include a signal terminal 197, and a ground terminal connected with the ground area of the camera module 190. The signal terminal 197 may be electrically connected to a signal line of the printed circuit board 150. The ground terminal may include, for example, a conductive pad 198 formed in a direction toward the vapor chamber 152. The conductive pad 198 may face a surface of the vapor chamber 152. The conductive pad 198 may be electrically coupled to the vapor chamber 152. For example, the conductive pad 198 and the vapor chamber 152 may be configured to be electrically open for DC signals and electrically short-circuited for AC signals.

According to an embodiment, the vapor chamber 152 may be disposed to cover at least a portion of the plate structure 142, when viewed from the rear surface of the electronic device 100. According to an embodiment, the vapor chamber 152 may be formed to have conductivity. For example, the vapor chamber 152 may include a metallic material. At least a portion of the surface of the vapor chamber 152 may be disposed to face the conductive pad 198 of the connector 199 of the camera module 190. According to an embodiment, the vapor chamber 152 may be electrically coupled to the conductive pad 198. According to an embodiment, the vapor chamber 152 may be configured to dissipate heat from electrical components included in the printed circuit board 150.

According to an embodiment, the vapor chamber 152 may be formed to have a specific size or more to provide sufficient space for internal working fluids to circulate. For example, the vapor chamber 152 may be formed to have a width of at least 8 mm.

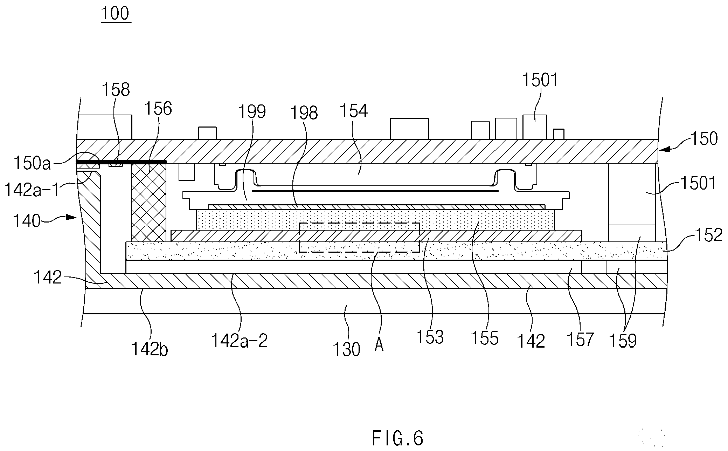

FIG. 6 is a sectional view of an electronic device, according to an embodiment;

Referring to FIG. 6, the electronic device 100 may include a plate structure 142, a display 130, a printed circuit board 150, a vapor chamber 152, an insulating adhesive member 157, an electrical absorption member 153, and a conductive structure 156.

According to an embodiment, the display 130 may be disposed on the second surface 142b of the plate structure 142 and exposed to the surface of the electronic device 100. According to some embodiments, the electronic device 100 may include a display module including the display 130 and a cover (e.g., the front plate 120 of FIG. 3).

According to an embodiment, the plate structure 142 may include a metal material. The plate structure 142 may have a first surface 142a on which the vapor chamber 152 and the printed circuit board 150 are disposed, and a second surface 142b on which the display 130 is disposed. The insulating adhesive member 157 and the vapor chamber 152 may be disposed on a portion of the first surface 142a of the plate structure 142. The plate structure 142 and the vapor chamber 152 may be physically coupled to each other by the insulating adhesive member 157.

According to an embodiment, the plate structure 142 may be electrically coupled to the vapor chamber 152 through a varistor 158. For example, the plate structure 142 may be electrically connected to the vapor chamber 152 within a specific voltage range. For example, the varistor 158 may electrically insulate the vapor chamber 152 from the plate structure 142 with respect to a lower voltage electrical signal, and may electrically connect the vapor chamber 152 to the plate structure 142 with respect to the higher voltage electrical signal. For example, the varistor 158 may electrically connect the vapor chamber 152 to the plate structure 142 with respect to the AC signal having a specific frequency, and may electrically insulate the vapor chamber 152 to the plate structure 142 with respect to the DC signal. For example, the AC signal may include static electricity. According to various embodiments, the varistor 158 may be disposed on the printed circuit board 150.

According to one embodiment, the first surface 142a of the plate structure 142 may include a first area 142a-1 directly connected to the varistor 158 and a second area 142a-2 in which the vapor chamber 152 is disposed and the insulating adhesive member 157 is directly disposed. According to one embodiment, the plate structure 142 and the vapor chamber 152 may not be conducted to each other with respect to the DC signals or the lower voltage signals by the insulating adhesive member 157. According to one embodiment, the plate structure 142 and the vapor chamber 152 may be electrically coupled to each other with respect to the AC signals or the higher voltage signals by the varistor 158.

According to an embodiment, the printed circuit board 150 may include the corresponding connector 154 coupled to the connector 199 of the camera module 190. According to an embodiment, the printed circuit board 150 may be electrically connected to the camera module 190 through the connector 199 and the corresponding connector 154. For example, a control circuit to control the camera module 190 may be disposed on the printed circuit board 150. According to various embodiments, the varistor 158 may be disposed on the printed circuit board 150. In this case, the surface of the printed circuit board 150 may be connected to the plate structure 142 through the conductive structure 156. For example, the printed circuit board 150 may include a conductive area connected to the varistor 158, and the plate structure 142 may be connected to the conductive area by the conductive structure 156.

According to an embodiment, the camera connector 199 may include a conductive pad 198 electrically connected to the ground area of the camera module 190. For example, the conductive pad 198 may be formed in a direction toward the vapor chamber 152. The conductive pad 198 may be electrically coupled to the vapor chamber 152. According to an embodiment, the electrical absorption member 153 and a conductive buffer member 155 may be interposed between the camera connector 199 and the vapor chamber 152.

According to an embodiment, the conductive buffer member 155 may be connected to the conductive pad 198 of the camera connector 199. For example, the conductive buffer member 155 may include the ground area of the camera module 190. Accordingly, the conductive buffer member 155 may include a conductive sponge. According to an embodiment, the conductive buffer member 155 may prevent the camera connector 199 and the plate structure 142 from being damaged. According to an embodiment, the conductive buffer member 155 may be disposed on the electrical absorption member 153. According to an embodiment, the conductive buffer member 155 may be interposed while being compressed, between the connector 199 of the camera module 190 and the electrical absorption member 153.

According to an embodiment, the electrical absorption member 153 may be disposed between the conductive buffer member 155 and the vapor chamber 152. The electrical absorption member 153 may electrically couple the conductive buffer member 155 with the vapor chamber 152. For example, the electrical absorption member 153 may be configured such that the vapor chamber 152 and the conductive buffer member 155 are electrically open with respect to the DC signal and electrically short-circuited with respect to the AC signal. For example, the electrical absorption member 153 may be configured such that the vapor chamber 152 and the conductive buffer member 155 are electrically short-circuited with respect to a signal having a higher frequency, and electrically open with respect to a signal having a lower frequency. For example, when the higher voltage and the ESD (e.g., static electricity) having a higher voltage and a fine current are applied to the vapor chamber 152, some of a current of the ESD may flow to the conductive buffer member 155 and the ground of the camera module 199 through the electrical absorption member 153.

According to an embodiment, the conductive structure 156 may electrically connect the vapor chamber 152 with the varistor 158. For example, the varistor 158 may be disposed on the printed circuit board 150, and the conductive structure 156 may be configured to electrically connect the printed circuit board 150 and the vapor chamber 152.

According to an embodiment, the printed circuit board 150 may include a conductive area 150a electrically connected to the varistor 158 and the conductive structure 156. In this case, the conductive area 150a may be configured not to be directly connected to another electrical path (e.g., an electrical devices) included in the printed circuit board 150. For example, the conductive area 150a may be directly connected to only the varistor 158 and the conductive structure 156.

According to one embodiment, the conductive area 150a may be electrically connected to the ground area of the printed circuit board 150 through the conductive structure 156, the vapor chamber 152, and the electrical absorption member 153. For example, the conductive area 150a may not be directly connected to the ground area of the printed circuit board 150, but may be electrically connected through the conductive structure 156, the vapor chamber 152, and the electrical absorption member 153.

According to various embodiments, the conductive structure 156 may include a C-clip disposed on any one of the printed circuit board 150 or the vapor chamber 152 and configured to provide elastic force toward a remaining one. According to various embodiments, the conductive structure 156 may include a flexible circuit board extending from the vapor chamber 152. For example, the flexible circuit board may extend to the printed circuit board 150 on which the varistor 158 is mounted. For example, the flexible circuit board may connect the vapor chamber 152 to the plate structure 142, and the varistor 158 may be mounted on the flexible circuit board.

According to an embodiment, the vapor chamber 152 may be interposed between an electrical device 1501 disposed on the printed circuit board 150 and the plate structure 142. For example, the vapor chamber 152 may be configured to transfer heat emitted from the electric device 1501 to the plate structure 142. In this case, to efficiently transfer the heat, a thermally conductive adhesive member 159 may be disposed. For example, the thermally conductive adhesive member 159 may be interposed between the vapor chamber 152 and the electrical device 1501, and/or between the vapor chamber 152 and the plate structure 142.

According to an embodiment disclosure of the disclosure, the electronic device 100 may provide a ground connection structure to absorb the ESD (e.g., static electricity) applied to the metal part (e.g., the frame structure 141 of FIGS. 1 and FIG. 3) exposed on the surface. For example, referring to FIG. 6, the ground connection structure may include the housing 140, the vapor chamber 152, and the ground areas of the printed circuit board 150, and the camera module 190.

When viewed through the electrical path, the varistor 158 may be interposed between the housing 140 and the vapor chamber 152. When viewed through the electrical path, the electrical absorption member 153 may be interposed between the vapor chamber 152 and the ground of the camera module 190.

For example, when the ESD (e.g., the static electricity) is applied to the electronic device 100 (e.g., the frame structure 141 of FIGS. 1 and 3), the metal part (e.g., the plate structure 142) of the housing, the vapor chamber 152, and the ground area of the camera module 190 are electrically coupled to each other to serve as the ground.

For example, an ESD (e.g., static electricity) may have various frequency bands. The ESD in the low frequency band may be blocked by the varistor 158 and the insulating adhesive member 157 to be prevented from flowing to the ground area of the printed circuit board 150. For example, the ESD in the high frequency band may be distributed into the vapor chamber 152 and the ground area of the printed circuit board 150.

For example, when the current leaks from the inner part (e.g., the camera module 190) of the electronic device 100, the leakage current may not flow to the surface (e.g., the frame structure 141 of FIGS. 1 and 3) of the electronic device 100 by the electrical absorption member 153 and/or the varistor 158. For example, when the current leaks from the inner part (e.g., the printed circuit board 150) of the electronic device 100, the leakage current may not flow to the surface of the electronic device by the insulating adhesive member 157 and/or the varistor 158.

Therefore, according to embodiments of the disclosure, the electric shock of the user may be prevented, and the electrical component may be prevented from being broken due to the ESD and/or the erroneous operation of the electrical component may be prevented due to the ESD.

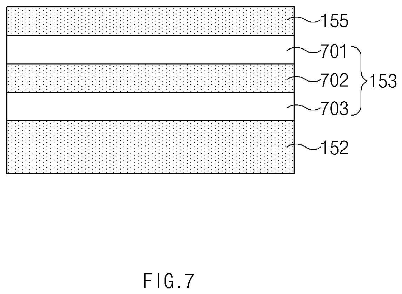

FIG. 7 is a sectional view illustrating a conductive buffer member, an electrical absorption member, and a vapor chamber of an electronic device, according to an embodiment. FIG. 7 is a sectional view of part "A" of FIG 6.

According to an embodiment, the electrical absorption member may include a first insulating layer 701 disposed on the conductive buffer member, a second insulating layer 703 disposed in the vapor chamber 152, and a conductive layer 702 interposed between the first insulating layer 701 and the second insulating layer 703. According to one embodiment, the conductive buffer member 155 may be electrically connected to the ground area of the camera module 190 and/or the ground area of the printed circuit board 150.

According to an embodiment, a first conductive layer 702 may be thicker than the first insulating layer 701 and/or the second insulating layer 703. According to an embodiment, the vapor chamber 152 may be thicker than the first conductive layer 702. According to an embodiment, the conductive buffer member 155 may be thicker than the first conductive layer 702.

According to one embodiment, the electrical absorption member 153 may electrically open the conductive buffer member 155 and the vapor chamber 152 with respect to a DC signal or a relatively low voltage electric signal. For example, when the leakage current flows through the ground area of the camera module 190 and/or the printed circuit board 150, the conductive buffer member 155 and the vapor chamber 152 may be insulated from each other by the first insulating layer 701.

According to one embodiment, the electrical absorption member 153 may electrically open the conductive buffer member 155 and the vapor chamber 152 with respect to a DC signal or a relatively low voltage electric signal. For example, when static electricity is applied to the electronic device 100, the thicker vapor chamber 152 may form a sufficient ground capacity together with the metal part of the housing 140 (e.g., the frame structure of FIGS. 1 and 3 and the plate structure 142). In this case, a portion of static electricity may flow through the electrical absorption member 153 to the ground area of the camera module 190 and/or the ground area of the printed circuit board 150.

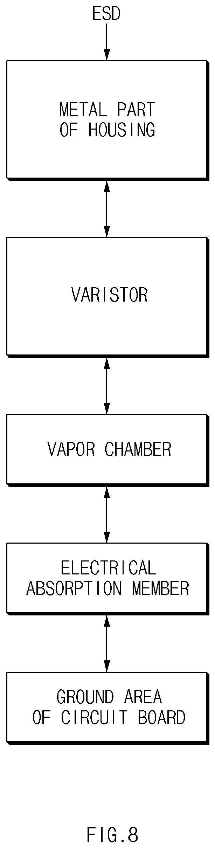

FIG. 8 is a view illustrating a ground structure of an electronic device, according to an embodiment.

According to one embodiment, the electronic device 100 may include a ground structure including a metal part of a housing (e.g., the housing 140 of FIG. 6), a vapor chamber (e.g., the vapor chamber 152 of FIG. 6), and the ground area of the circuit board (e.g., the printed circuit board 150 of FIG. 6).

In this case, the circuit board may be a camera substrate including a printed circuit board (e.g., the printed circuit board 150 of FIG. 3) of the electronic device 100, or a camera substrate included in a camera module (e.g., the camera module 190 of FIG. 3). In this case, the metal part of the housing may include the frame structure (e.g., the frame structure 141 of FIGS. 1 and 3) and the plate structure (e.g., the plate structure 142 of FIG. 6).

According to an embodiment, the electronic device may include a varistor and an electrical absorption member to prevent the current leaking from the circuit board from flowing to the metal part of the housing forming the surface of the electronic device. Accordingly, the electric shock of the user may be prevented.

According to an embodiment, when the ESD (e.g., the static electricity) is applied to the surface of the electronic device, the metal part of the housing and the vapor chamber provide the sufficient ground capacity, thereby preventing the camera module or the electrical components included in the printed circuit board from erroneously operating and/or broken.

According to one embodiment, when ESD is applied to the metal part of the housing, the ESD may flow to the vapor chamber (e.g., the vapor chamber 152 in FIG. 6) through the varistor (e.g., the varistor 158 in FIG. 6). The ESD in the low frequency band may be blocked by the electrical absorption member (e.g., the electrical absorption member 153 of FIG. 6). The ESD in the high frequency band may be distributed to the ground area of the circuit board through the electrical absorption member. According to various embodiments, the ESD may have various frequency bands. The ESD in the low frequency band is substantially a DC, and is blocked by a varistor (e.g., the varistor 158 of FIG. 6) and an electrical absorption member (e.g., the electrical absorption member 153 of FIG. 6) to prevent the ESD from being flowing to the ground area of the circuit board. ESD in the high frequency band may be distributed to the ground area of the vapor chamber (e.g., the vapor chamber 152 in Fig. 6) and the circuit board (e.g., the printed circuit board 150 in FIG. 6).

According to embodiments of the disclosure, the electronic device 100 may include the housing 110 including the metal part, in which the metal part includes the frame structure 141 forming a portion of a surface of the electronic device 100 and the plate structure 142 extending into an inner space of the housing 110, a printed circuit board 150 disposed in the plate structure 142, the camera module 190 disposed in the plate structure 142, in which the camera module 190 includes the connector 199 coupled to the printed circuit board, and the connector includes the conductive pad 198 electrically connected to a ground area of the camera module, the vapor chamber 152 interposed between the plate structure 142 and the printed circuit board 150, having a conductivity, and at least partially facing the conductive pad of the connector, an electrical absorption member 153 interposed between the vapor chamber 152 and the conductive pad 198, an insulating adhesive member 157 interposed between the vapor chamber 152 and the plate structure 142, and a varistor 158 electrically connect the vapor chamber 152 to the metal part.

According to various embodiments, the varistor 158 may be disposed in a first area of the printed circuit board 150 and may further include the conductive structure 156 to electrically connect the first area to the vapor chamber 152.

According to various embodiments, the conductive structure 156 may include a C-clip or a flexible printed circuit board (FPCB) disposed in any one of the vapor chamber 152 and the conductive area, and configured to provide elasticity to a remaining one.

According to various embodiments, at least one electrical device may be disposed in the printed circuit board 150, and the vapor chamber 152 may be disposed to make contact with the at least one electrical device to dissipate heat from the at least one electrical device 151.

According to various embodiments, the vapor chamber 152, the plate structure 142, and the frame structure 141 may form a heat dissipation path to dissipate heat emitted from the at least one electrical device.

According to various embodiments, the vapor chamber 152 and the conductive pad 198 may be electrically coupled to each other through the electrical absorption member 153.

According to various embodiment, the insulating adhesive member 157 may physically couple the vapor chamber 152 to the plate structure 142 and electrically insulate the vapor chamber 152 to the plate structure 142.

According to various embodiment, the electronic device may further include the conductive buffer member 155 interposed between the conductive pad 198 and the electrical absorption member 153.

According to various embodiments, the electronic device may include the conductive buffer member 155 including a conductive sponge interposed while being compressed, between the conductive pad 198 and the electrical absorption member 153.

According to various embodiments, the vapor chamber 152 may be disposed on a first surface 142a of the plate structure 142, and at least a portion of the connector 199 may be partially overlapped with the vapor chamber 152, when the first surface 142a is viewed from above.

According to various embodiments, the electronic device may further include a display module 130 disposed on a second surface 142b of the plate structure 142.

According to various embodiments, when an electrical signal having a specific voltage or less is applied, the varistor 158 may be configured to electrically open the vapor chamber 152 and the metal part.

According to various embodiments, when an electrical signal having a specific voltage or more, the varistor 158 may be configured to distribute a portion of the electrical signal.

According to various embodiment, the electrical absorption member 153 may include a plurality of layers, and the plurality of layers may include a first insulating layer 701 making contact with the conductive pad 198, a second insulating layer 703 making contact with the vapor chamber, and a conductive layer 702 interposed between the first insulating layer and the second insulating layer.

According to an embodiment, the first conductive layer 702 may be thicker than the first insulating layer 701 and/or the second insulating layer 703.

According to embodiments of the disclosure, an electronic device 100 may include a front plate 120, a rear plate 180 opposite to the front plate, a metal housing 110 extending to a space between the front plate 120 and the rear plate 180, a display 130 disposed in the metal housing such that the display 130 is viewed through the front plate 120, a conductive vapor chamber 152 interposed between the metal housing 110 and the rear plate, and a varistor 150 configured to be electrically coupled to the metal housing 110 and the vapor chamber 152. The varistor 158 may be configured to form an electric short circuit between the metal housing 110 and the vapor chamber 152, when static electricity is applied to the metal housing 110.

According to various embodiment, the electronic device may further include a circuit board 150 interposed between the vapor chamber 152 and the rear plate 180, and including a ground area, and an electrical absorption member 153 configured to electrically couple the ground area of the circuit board 150 and the vapor chamber 152. The electrical absorption member 153 may be configured to form an electric short circuit between the vapor chamber 152 and the ground area, when static electricity is applied to the metal housing 110.

According to various embodiments, the varistor 158 may further include a conductive structure 156 disposed on the circuit board 150 and extending to the vapor chamber 152 to electrically connect the vapor chamber 152 to the varistor 158.

According to various embodiments, the electronic device may further include an insulating adhesive member 157 physically couple the vapor chamber 152 to the metal housing 110, such that the vapor chamber 152 is insulated from the metal housing 110 with respect to a DC signal.

According to various embodiments, when an electrical signal having a specific voltage or more is applied, the varistor 158 may be configured to distribute a portion of the electrical signal.

Various embodiments of the disclosure and terms used herein are not intended to limit the technical features described in the disclosure to specific embodiments, and it should be understood that the embodiments and the terms include modification, equivalent and/ or alternative on the corresponding embodiments described herein. With regard to description of drawings, similar components may be assigned with similar reference numerals. The terms of a singular form may include plural forms unless otherwise specified. In the disclosure, the wording "A or B", "at least one of A and/or B", "A, B, or C", or "at least one of A, B, and/or C" may include all possible combinations of one or more of the associated listed items. The expressions, such as "first", or "second" may express various components regardless of the order or priority of the components and may be used to distinguish a component from another component, not to limit the elements. It will be understood that when a component (e.g., a first component) is referred to as being "(operatively or communicatively) coupled with/to" or "connected to" another component (e.g., a second component), the component may be directly coupled with/to or connected to the another component or an intervening component (e.g., a third component) may be present therebetween.

According to the disclosure, the wording "adapted to or configured to" used herein may be interchangeably used as, for example, the wording "suitable for", "having the capacity to", "changed to~", "made to~", "capable of ~", or "designed to" in hardware or software depending on situations. Under a certain situation, the wording "a device configured to~" may refer to that the device is "capable of" operating together with another device or other components. For example, a "processor configured to perform A, B, and C" may refer to a dedicated processor (e.g., an embedded processor) for performing a corresponding operation or a generic-purpose processor (e.g., a central processing unit (CPU) or an application processor (AP)) which may perform corresponding operations by executing one or more software programs which are stored in a memory device.

The term "module" used in this specification may include a unit implemented in hardware, software, or firmware. For example, the term "module" may be interchangeably used with the term "logic", "logic block", "component", "circuit", and the like. The "module" may be an integrated component, a minimum unit for performing one or more functions, or a part thereof. The "module" may be implemented mechanically or electronically. For example, the module may include a well-known or to-be-developed application-specific integrated circuit (ASIC) chip, a field-programmable gate arrays (FPGAs), or a programmable logic device.

According to various embodiments, at least a portion of a device (e.g., modules or functions thereof) or a method (e.g., operations) according to various embodiments may be, for example, implemented by instructions stored in a computer-readable storage media in the form of a program module. The instruction, when executed by a processor, may cause the processor to perform a function corresponding to the instruction. A computer-readable recording medium may include a hard disk, a floppy disk, a magnetic media (e.g., a magnetic tape), an optical media (e.g., a compact disc read only memory (CD-ROM) and a digital versatile disc (DVD), a magneto-optical media (e.g., a floptical disk)), and an embedded memory. The instructions may include codes formed by a compiler or codes executable by an interpreter.

Each of components (e.g., a module or a program) according to various embodiments may include a single entity or a plurality of entities; some of the above-described relevant sub-components may be omitted, or any other sub component may be further included in. Alternatively additionally, some components (e.g., a module or a program) may be integrated into one entry combined with each other so as to form one entity, such that the entity identically or similarly performs the functions performed by each of the components before the integration. According to various embodiments, operations executed by modules, program modules, or other components may be executed by a successive method, a parallel method, a repeated method, or a heuristic method. Alternatively, at least some of the operations may be executed in another order or may be omitted, or any other operation may be added.

## Claims

1. An electronic device (100) comprising:
a housing (110) including a metal part, wherein the metal part includes:
a frame structure (141) forming a portion of a surface of the electronic device; and
a plate structure (142) extending into an inner space of the housing;
a printed circuit board (150) disposed in the plate structure;
a camera module (190) disposed in the plate structure, wherein the camera module includes a connector (199) electrically and mechanically coupled to the printed circuit board, and wherein the connector includes an electrically conductive pad (198) electrically connected to a ground area of the camera module;
a vapor chamber (152) disposed between the plate structure and the printed circuit board, having a heat conductivity and an electrical conductivity, and at least partially facing the conductive pad of the connector, wherein the vapor chamber is configured to dissipate heat from at least one electrical device disposed in the printed circuit board; **characterized in that**:
an electrical absorption member (153) disposed between the vapor chamber and the conductive pad and configured that the vapor chamber (152) and the conductive buffer member (155) are electrically short-circuited with respect to a signal having a higher frequency, and electrically open with respect to a DC signal or a signal having a lower frequency an electrically insulating adhesive member (157) disposed between the vapor chamber and
the plate structure; and
a varistor (158) electrically connect the vapor chamber to the metal part.

2. The electronic device of claim 1, further comprising a conductive structure (156), and
wherein the varistor is disposed in a first area of the printed circuit board, and
wherein the conductive structure electrically connects the first area to the vapor chamber.

3. The electronic device of claim 2, wherein the conductive structure includes:
a C-clip disposed in one of the vapor chamber and the conductive area, and configured to provide elasticity to a remaining one of the vapor chamber and the conductive area; or
a flexible printed circuit board, FPCB.

4. The electronic device of claim 1, wherein the vapor chamber is disposed to make contact with the at least one electrical device to dissipate heat from the at least one electrical device.

5. The electronic device of claim 4, wherein the vapor chamber, the plate structure, and the frame structure form a heat dissipation path to dissipate the heat emitted from the at least one electrical device.

6. The electronic device of claim 1, wherein the vapor chamber and the conductive pad are electrically coupled to each other through the electrical absorption member.

7. The electronic device of claim 1, wherein the insulating adhesive member physically couples the vapor chamber to the plate structure and electrically insulates the vapor chamber from the plate structure.

8. The electronic device of claim 1, further comprising:
a conductive buffer member (155) interposed between the conductive pad and the electrical absorption member.

9. The electronic device of claim 8, wherein the conductive buffer member includes:
a conductive sponge interposed while being compressed, between the conductive pad and
the electrical absorption member.

10. The electronic device of claim 1, wherein the vapor chamber is disposed on a first surface of the plate structure, and
wherein at least a portion of the connector is partially overlapped with the vapor chamber, when the first surface is viewed from above.

11. The electronic device of claim 10, further comprising:
a display module (130) disposed on a second surface of the plate structure.

12. The electronic device of claim 1, wherein the varistor is configured to:
electrically open the vapor chamber and the metal part, when an electrical signal is applied with a specific voltage or less.

13. The electronic device of claim 1, wherein the varistor is configured to:
distribute a portion of an electrical signal, when the electrical signal is applied with a specific voltage or more.

14. The electronic device of claim 1, wherein the electrical absorption member includes:
a plurality of layers, and
wherein the plurality of layers include:
a first insulating layer (701) making contact with the conductive pad a second insulating layer (703) making contact with the vapor chamber; and
a conductive layer (702) interposed between the first insulating layer and the second insulating layer.

15. The electronic device of claim 14, wherein the conductive layer is thicker than the first insulating layer and the second insulating layer.

## Patentansprüche

1. Elektronische Vorrichtung (100), umfassend:
ein Gehäuse (110), das ein Metallteil beinhaltet, wobei das Metallteil Folgendes beinhaltet:
eine Rahmenstruktur (141), die einen Abschnitt einer Fläche der elektronischen Vorrichtung bildet; und
eine Plattenstruktur (142), die sich in einen Innenraum des Gehäuses erstreckt;
eine Leiterplatte (150), die in der Plattenstruktur angeordnet ist;
ein Kameramodul (190), das in der Plattenstruktur angeordnet ist, wobei das Kameramodul einen Steckverbinder (199) enthält, der elektrisch und mechanisch mit der Leiterplatte gekoppelt ist, und wobei der Steckverbinder ein elektrisch leitfähiges Pad (198) enthält, das elektrisch mit einem Erdungsbereich des Kameramoduls verbunden ist;
eine Dampfkammer (152), die zwischen der Plattenstruktur und der Leiterplatte angeordnet ist, eine Wärmeleitfähigkeit und eine elektrische Leitfähigkeit aufweist und dem leitfähigen Pad des Steckverbinders mindestens teilweise zugewandt ist, wobei die Dampfkammer konfiguriert ist, um Wärme von mindestens einer elektrischen Vorrichtung abzuleiten, die in der Leiterplatte angeordnet ist; **gekennzeichnet durch**:
ein elektrisches Absorptionselement (153), das zwischen der Dampfkammer und dem leitfähigen Pad angeordnet und so konfiguriert ist, dass die Dampfkammer (152) und das leitfähige Pufferelement (155) in Bezug auf ein Signal mit einer höheren Frequenz elektrisch kurzgeschlossen und in Bezug auf ein Gleichstromsignal oder ein Signal mit einer niedrigeren Frequenz elektrisch offen sind;
ein elektrisch isolierendes Haftelement (157), das zwischen der Dampfkammer und der Plattenstruktur angeordnet ist; und
einen Varistor (158), der die Dampfkammer elektrisch mit dem Metallteil verbindet.

2. Elektronische Vorrichtung nach Anspruch 1, ferner umfassend eine leitfähige Struktur (156), und
wobei der Varistor in einem ersten Bereich der Leiterplatte angeordnet ist, und
wobei die leitfähige Struktur den ersten Bereich elektrisch mit der Dampfkammer verbindet.

3. Elektronische Vorrichtung nach Anspruch 2, wobei die leitfähige Struktur Folgendes beinhaltet:
einen Sprengring, der in einem von der Dampfkammer und dem leitfähigen Bereich angeordnet und so konfiguriert ist, dass er einem verbleibenden von der Dampfkammer und dem leitfähigen Bereich Elastizität verleiht; oder
eine flexible Leiterplatte, FPCB.

4. Elektronische Vorrichtung nach Anspruch 1, wobei die Dampfkammer so angeordnet ist, dass sie mit der mindestens einen elektrischen Vorrichtung in Kontakt kommt, um Wärme von der mindestens einen elektrischen Vorrichtung abzuleiten.

5. Elektronische Vorrichtung nach Anspruch 4, wobei die Dampfkammer, die Plattenstruktur und die Rahmenstruktur einen Wärmeableitungspfad bilden, um die von der mindestens einen elektrischen Vorrichtung abgegebene Wärme abzuleiten.

6. Elektronische Vorrichtung nach Anspruch 1, wobei die Dampfkammer und das leitfähige Pad über das elektrische Absorptionselement elektrisch miteinander gekoppelt sind.

7. Elektronische Vorrichtung nach Anspruch 1, wobei das isolierende Haftelement die Dampfkammer physisch mit der Plattenstruktur gekoppelt und die Dampfkammer elektrisch von der Plattenstruktur isoliert.

8. Elektronische Vorrichtung nach Anspruch 1, ferner umfassend:
ein leitfähiges Pufferelement (155), das zwischen dem leitfähigen Pad und dem elektrischen Absorptionselement angeordnet ist.

9. Elektronische Vorrichtung nach Anspruch 8, wobei das leitfähige Pufferelement Folgendes beinhaltet:
einen leitfähigen Schwamm, der zusammengedrückt zwischen dem leitfähigen Pad und dem elektrischen Absorptionselement angeordnet ist.

10. Elektronische Vorrichtung nach Anspruch 1, wobei die Dampfkammer auf einer ersten Fläche der Plattenstruktur angeordnet ist, und
wobei mindestens ein Abschnitt des Steckverbinders die Dampfkammer teilweise überlappt,
wenn die erste Fläche von oben betrachtet wird.

11. Elektronische Vorrichtung nach Anspruch 10, ferner umfassend:
ein Anzeigemodul (130), das auf einer zweiten Fläche der Plattenstruktur angeordnet ist.

12. Elektronische Vorrichtung nach Anspruch 1, wobei der Varistor konfiguriert ist zum:
elektrischen Öffnen der Dampfkammer und des Metallteils, wenn ein elektrisches Signal mit einer spezifischen Spannung oder weniger angelegt ist.

13. Elektronische Vorrichtung nach Anspruch 1, wobei der Varistor konfiguriert ist zum:
Verteilen eines Abschnitts eines elektrischen Signals, wenn das elektrische Signal mit einer spezifischen Spannung oder mehr angelegt ist.

14. Elektronische Vorrichtung nach Anspruch 1, wobei das elektrische Pufferelement Folgendes beinhaltet:
eine Vielzahl von Schichten, und
wobei die Vielzahl von Schichten Folgendes beinhaltet:
eine erste Isolierschicht (701), die mit dem leitfähigen Pad in Kontakt steht
eine zweite Isolierschicht (703), die mit der Dampfkammer in Kontakt steht; und
eine leitfähige Schicht (702), die zwischen der ersten Isolierschicht und der zweiten Isolierschicht angeordnet ist.

15. Elektronische Vorrichtung nach Anspruch 14, wobei die leitfähige Schicht dicker ist als die erste Isolierschicht und die zweite Isolierschicht.

## Revendications

1. Dispositif électronique (100), comprenant :
un boîtier (110) comprenant une partie métallique, dans lequel la partie métallique comprend :
une structure de cadre (141) formant une partie d'une surface du dispositif électronique ;
une structure de plaque (142) s'étendant dans un espace intérieur du boîtier ;
une carte de circuit imprimé (150) disposée dans la structure de plaque ;
un module de caméra (190) disposé dans la structure de plaque, dans lequel le module de caméra comprend un connecteur (199) couplé électriquement et mécaniquement à la carte de circuit imprimé, et dans lequel le connecteur comprend un plot électriquement conducteur (198) connectée électriquement à une zone de mise à la terre du module de caméra ;
une chambre à vapeur (152) disposée entre la structure de plaque et la carte de circuit imprimé, ayant une conductivité thermique et une conductivité électrique, et au moins partiellement faisant face au plot électriquement conducteur du connecteur, dans lequel la chambre à vapeur est configurée pour dissiper la chaleur d'au moins un dispositif électrique disposé dans la carte de circuit imprimé ; **caractérisé en ce que** :
un élément d'absorption électrique (153) disposé entre la chambre à vapeur et le plot conducteur et configuré de telle sorte que la chambre à vapeur (152) et l'élément de tampon conducteur (155) soient électriquement court-circuités par rapport à un signal ayant une fréquence plus élevée, et électriquement ouverts par rapport à un signal DC ou à un signal ayant une fréquence plus basse ;
un élément adhésif électriquement isolant (157) disposé entre la chambre à vapeur et la structure de plaque ; et
une varistance (158) connectant électriquement la chambre à vapeur à la partie métallique.

2. Dispositif électronique de la revendication 1, comprenant en outre une structure conductrice (156), et
dans lequel la varistance est disposée dans une première zone de la carte de circuit imprimé, et
dans lequel la structure conductrice connecte électriquement la première zone à la chambre à vapeur.

3. Dispositif électronique de la revendication 2, dans lequel la structure conductrice comprend :
une pince en C disposée dans l'une de la chambre à vapeur et la zone conductrice, et
configurée pour donner de l'élasticité à une restante de la chambre à vapeur et la zone conductrice ; ou
une carte de circuit imprimé flexible, FPCB.

4. Dispositif électronique de la revendication 1, dans lequel la chambre à vapeur est disposée de manière à entrer en contact avec au moins un dispositif électrique pour dissiper la chaleur de l'au moins un dispositif électrique.

5. Dispositif électronique de la revendication 4, dans lequel la chambre à vapeur, la structure de plaque et la structure de cadre forment un chemin de dissipation de chaleur pour dissiper la chaleur émise par l'au moins un dispositif électrique.

6. Dispositif électronique de la revendication 1, dans lequel la chambre à vapeur et le plot conducteur sont couplés électriquement l'un à l'autre par l'intermédiaire de l'élément d'absorption électrique.

7. Dispositif électronique de la revendication 1, dans lequel l'élément adhésif isolant couple physiquement la chambre à vapeur à la structure de plaque et isole électriquement la chambre à vapeur de la structure de plaque.

8. Dispositif électronique de la revendication 1, comprenant en outre :
un élément de tampon conducteur (155) interposé entre le plot conducteur et l'élément d'absorption électrique.

9. Dispositif électronique de la revendication 8, dans lequel l'élément de tampon conducteur (160) comprend :
une éponge conductrice interposée, tout en étant comprimée, entre le tampon conducteur et
l'élément d'absorption électrique.

10. Dispositif électronique de la revendication 1, dans lequel la chambre à vapeur est disposée sur une première surface de la structure de plaque, et
dans lequel au moins une partie du connecteur est partiellement superposée à la chambre à vapeur, lorsque la première surface est vue d'en haut.

11. Dispositif électronique de la revendication 10, comprenant en outre :
un module d'affichage (130) disposé sur une deuxième surface de la structure de plaque.

12. Dispositif électronique de la revendication 1, dans lequel la varistance est configurée pour :
ouvrir électriquement la chambre à vapeur et la partie métallique, lorsqu'un signal électrique est appliqué avec une tension spécifique ou moins.

13. Dispositif électronique de la revendication 1, dans lequel la varistance est configurée pour :
distribuer une partie d'un signal électrique, lorsque le signal électrique est appliqué avec une tension spécifique ou plus.

14. Dispositif électronique de la revendication 1, dans lequel le membre d'absorption électrique comprend :
une pluralité de couches, et
dans lequel la pluralité de couches comprend :
une première couche isolante (701) en contact avec le plot conducteur,
une deuxième couche isolante (703) en contact avec la chambre à vapeur ; et
une couche conductrice (702) interposée entre la première couche isolante et la deuxième couche isolante.

15. Dispositif électronique de la revendication 14, dans lequel la couche conductrice est plus épaisse que la première couche isolante et la deuxième couche isolante.
